# EUROPÄISCHE PATENTANMELDUNG

(11) **EP 4 529 021 A1**
(43) Veröffentlichungstag der Anmeldung: **26.03.2025**
(21) Anmeldenummer: 23198850.2
(22) Anmeldetag: 21.09.2023
(51) Int. Cl.: H03K 17/0812, H03K 17/12

(54) **VERLUSTLEISTUNGSOPTIMIERTE STROMSTELLERSCHALTUNG**

(71) Anmelder: Siemens Aktiengesellschaft, 80333 München (DE)
(72) Erfinder: Hartwig, Raphael, 92342 Freystadt (DE); Hensler, Alexander, 91466 Gerhardshofen (DE); Kiesel, Alexander, 82467 Garmisch-Partenkirchen (DE); Weis, Benno, 91334 Hemhofen (DE)
(74) Vertreter: Siemens Patent Attorneys

(57) **Zusammenfassung**

Eine Stromstellerschaltung weist eine Mehrzahl von Schaltelementen (1, 2) auf, die jeweils einen ersten und einen zweiten Lastanschluss (3, 4) und einen Steueranschluss (7) aufweisen. Die ersten Lastanschlüsse (3) sind miteinander verbunden. Auch die zweiten Lastanschlüsse (4) sind miteinander verbunden. Die Steueranschlüsse (7) sind mittels einer jeweiligen Verbindungsleitung (9) mit einem für die Steueranschlüsse (7) gemeinsamen Ausgang (10) einer Treiberschaltung (11) verbunden. In mindestens einer der Verbindungsleitungen (9) ist ein Schalter (12, 12', 12") angeordnet, so dass ein von der Treiberschaltung (11) über den Ausgang (10) ausgegebenes Steuersignal (C) je nachdem, ob der jeweilige Schalter (12, 12', 12") sich in einem durchgeschalteten oder in einem gesperrten Zustand befindet, dem entsprechenden Steueranschluss (7) zugeführt wird oder nicht. Die Stromstellerschaltung weist eine Steuerschaltung (13) auf, von der ein jeweiliges Zusatzsignal (Z, Z', Z") generiert wird, das dem jeweiligen Schalter (12, 12', 12") zugeführt wird und aufgrund dessen der jeweilige Schalter (12, 12', 12") in den durchgeschalteten oder in den gesperrten Zustand überführt wird.

## Beschreibung

Die vorliegende Erfindung geht aus von einer Stromstellerschaltung,
- wobei die Stromstellerschaltung ein Schaltelement aufweist, das einen ersten und einen zweiten Lastanschluss und einen Steueranschluss aufweist,
- wobei der Steueranschluss mittels einer Verbindungsleitung mit einem Ausgang einer Treiberschaltung verbunden ist.

Eine derartige Stromstellerschaltung ist allgemein bekannt. Sie wird insbesondere als Teil einer Brückenschaltung in einem Umrichter verwendet, mittels dessen eine Wechselspannung in eine Gleichspannung oder umgekehrt eine Gleichspannung in eine Wechselspannung gewandelt wird. Rein beispielhaft kann auf die EP 3 955 717 A1 verwiesen werden.

Stromstellerschaltungen werden zu den verschiedensten Zwecken eingesetzt. Sie weisen bei Betrieb im Bereich ihrer Auslegung (Nennlast) oftmals einen hohen Wirkungsgrad von weit über 90 % auf, manchmal sogar von über 96 %. Der Wirkungsgrad verringert sich jedoch bei geringeren Belastungen (Teillastbetrieb) oftmals drastisch, manchmal auf deutlich unter 90 %, beispielsweise auf ca. 86 % bei einer Belastung mit nur 10 % der Nennlast. Der Grund für den verringerten Wirkungsgrad besteht darin, dass die Schaltverluste weitgehend unabhängig von dem geschalteten Strom sind.

Die Problematik, dass eine Stromstellerschaltung nur mit Teillast betrieben wird, stellt sich in vielen Anwendungsfällen. Beispielsweise wird ein Kraftfahrzeug üblicherweise nur beim Beschleunigen und eventuell bei einer Fahrt bergauf mit einer nennenswerten Last betrieben, während die Fahrt mit einer konstanten Geschwindigkeit einen erheblich geringeren Leistungsbedarf aufweist. Eine ähnliche Situation findet sich beispielsweise auch bei einem Regalbediengerät, bei dem ebenfalls zwar beim Beschleunigen und beim Verzögern ein erheblicher Leistungsbedarf besteht, während der Fahrt mit konstanter Geschwindigkeit hingegen nur ein deutlich geringerer Leistungsbedarf.

Im Stand der Technik ist es bekannt, als Schaltelement einen Feldeffekttransistor oder einen IGBT zu verwenden und im Teillastbetrieb die Gatespannung abzusenken. Rein beispielhaft kann auf die US 2012/0 194 119 A1 verwiesen werden. Diese Vorgehensweise wird beispielsweise bei Schaltelementen auf SiC- und Si-Basis eingesetzt. Durch das Absenken der Gatespannung ist es möglich, das Schaltelement im Teillastbetrieb schneller zu schalten. Zum Umschalten vom durchgeschalteten in den gesperrten Zustand und umgekehrt wird also eine geringere Zeit benötigt, so dass die Schaltverluste verringert werden. Bei Nennlast und auch bei Überlast hingegen wird das Schaltelement langsamer umgeschaltet, damit keine unzulässigen Spannungsüberschwingungen auftreten.

Bei einem Schaltelement auf GaN-Basis und bei einem Niederspannungsschalter ist diese Vorgehensweise nicht möglich, da hierdurch ein parasitäres Einschalten bewirkt werden kann. Derartige Schaltelemente werden daher stets mit ihrer normalen Schaltspannung (typisch +5 V und 0 V) geschaltet. Die Verlustleistung im Teillastbetrieb wird hingenommen.

Die Aufgabe der vorliegenden Erfindung besteht darin, eine Stromstellerschaltung der eingangs genannten Art derart weiterzuentwickeln, dass die Verlustleistung insbesondere im Teillastbetrieb verringert wird und somit der Wirkungsgrad im Teillastbetrieb erhöht wird.

Die Aufgabe wird durch eine Stromstellerschaltung mit den Merkmalen des Anspruchs 1 gelöst. Vorteilhafte Ausgestaltungen der Stromstellerschaltung sind Gegenstand der abhängigen Ansprüche 2 bis 13.

Erfindungsgemäß wird eine Stromstellerschaltung geschaffen,
- wobei die Stromstellerschaltung eine Mehrzahl von Schaltelementen aufweist, die jeweils einen ersten und einen zweiten Lastanschluss und einen Steueranschluss aufweisen,
- wobei die ersten Lastanschlüsse miteinander verbunden sind und die zweiten Lastanschlüsse miteinander verbunden sind,
- wobei die Steueranschlüsse mittels einer jeweiligen Verbindungsleitung mit einem für die Steueranschlüsse gemeinsamen Ausgang einer Treiberschaltung verbunden sind,
- wobei in mindestens einer der Verbindungsleitungen ein Schalter angeordnet ist, so dass ein von der Treiberschaltung über den Ausgang ausgegebenes Steuersignal je nachdem, ob der jeweilige Schalter sich in einem durchgeschalteten oder in einem gesperrten Zustand befindet, dem entsprechenden Steueranschluss zugeführt wird oder nicht, und
- wobei die Stromstellerschaltung eine Steuerschaltung aufweist, von der ein jeweiliges Zusatzsignal generiert wird, das dem jeweiligen Schalter zugeführt wird und aufgrund dessen der jeweilige Schalter in den durchgeschalteten oder in den gesperrten Zustand überführt wird.

Es sind also mehrere Schaltelemente vorhanden, die einander parallel geschaltet sind und über einen einzelnen Ausgang der Treiberschaltung geschaltet werden können. Aufgrund der Schalter in zumindest einem Teil der Verbindungsleitungen können jedoch einzelne Schaltelemente abgeschaltet werden, so dass sie unabhängig von dem über den Ausgang der Treiberschaltung ausgegebenen Steuersignal nicht mehr durchgeschaltet werden. Somit ist es möglich, bei Nennlast und bei Überlast alle Schaltelemente anzusteuern und bei Teillast einzelne der Schaltelemente nicht anzusteuern, so dass die nicht angesteuerten Schaltelemente permanent gesperrt sind und der Strom nur über die verbleibenden Schaltelemente geführt wird.

Umladeverluste können durch die erfindungsgemäße Stromstellerschaltung und deren Betrieb zwar nicht verringert werden. Allerdings können die Einschaltverluste und auch die Gate-Umladeverluste reduziert werden.

Es ist möglich, dass die Verbindungsleitungen, ausgehend von dem Steueranschluss des jeweiligen Schaltelements, individuell (also einzeln und damit im Ergebnis parallel) direkt bis zum Ausgang der Treiberschaltung geführt sind. In der Regel sind die Verbindungsleitungen jedoch an einem Knotenpunkt miteinander verbunden, so dass die Verbindungsleitungen zwischen dem Knotenpunkt und dem Ausgang der Treiberschaltung als gemeinsame, einheitliche Verbindungsleitung ausgebildet sind. Die Schalter sind in diesem Fall in der jeweiligen (individuellen) Verbindungsleitung zwischen dem Knotenpunkt und dem jeweiligen Steueranschluss angeordnet. Sofern der vom Ausgang gelieferte Treiberstrom mittels eines Widerstands eingestellt wird, ist dieser Widerstand vorzugsweise zwischen dem Knotenpunkt und dem Ausgang der Treiberschaltung angeordnet.

Diese Ausgestaltung hat zwar zur Folge, dass dann, wenn die Stromstellerschaltung mit hoher Last betrieben wird (Nennlast und Überlast), die Schaltelemente relativ langsam geschaltet werden. Dies ist bei Nennlast und Überlast jedoch hinnehmbar, weil der Nennlastbetrieb und der Überlastbetrieb oftmals nur kurzzeitig auftreten und darüber hinaus bei diesen Betriebsweisen die Schaltverluste nicht dominant sind. Diese Ausgestaltung hat aber auch zur Folge, dass dann, wenn die Stromstellerschaltung mit geringer Last betrieben wird (Teillastbetrieb) und demzufolge der jeweilige Schalter in den gesperrten Zustand überführt ist, der vom Ausgang gelieferte Treiberstrom nur noch den Steueranschlüssen der verbleibenden Schaltelemente zugeführt wird, so dass diese Schaltelemente im Teillastbetrieb schneller geschaltet werden können.

Es ist möglich, dass der Steuerschaltung ein mittels der Stromstellerschaltung zu schaltender Sollstrom zugeführt wird. In diesem Fall kann die Steuerschaltung anhand des Sollstroms entscheiden, ob sie mindestens einen der Schalter in den gesperrten Zustand überführt oder ob sie alle Schalter im durchgeschalteten Zustand hält. Im Falle einer Umwandlung einer Wechselspannung in eine Gleichspannung oder umgekehrt ist der Sollstrom üblicherweise nicht der über eine Periode der Wechselspannung variierende Stromwert, sondern der über die Periode gemittelte Effektivwert. Auch ein Variieren über die Periode der Wechselspannung ist jedoch möglich.

Alternativ ist es möglich, dass der Steuerschaltung ein mittels der Stromstellerschaltung geschalteter Iststrom zugeführt wird. In diesem Fall kann die Steuerschaltung anhand des Iststroms entscheiden, ob sie mindestens einen der Schalter in den gesperrten Zustand überführt oder ob sie alle Schalter im durchgeschalteten Zustand hält. Im Falle einer Umwandlung einer Wechselspannung in eine Gleichspannung oder umgekehrt ist der Iststrom üblicherweise nicht der über die Periode gemittelte Effektivwert, sondern der über eine Periode der Wechselspannung variierende Stromwert.

Die letztgenannte Vorgehensweise bietet insbesondere den Vorteil, dass auch bei hohen Lastanforderungen während Phasen, während derer temporär nur ein geringer Strom geschaltet werden muss, das ebenso temporäre Öffnen mindestens eines der Schalter möglich ist.

Vorzugsweise erfolgt ein Überführen des jeweiligen Schalters vom durchgeschalteten in den gesperrten Zustand nur dann, wenn die Schaltelemente sich aufgrund des von der Treiberschaltung ausgegebenen Steuersignals in einem gesperrten Zustand befinden. Dadurch wird ein anderenfalls mögliches parasitäres Einschalten des entsprechenden Schaltelements zuverlässig verhindert. Für das Überführen des jeweiligen Schalters vom gesperrten in den durchgeschalteten Zustand wird vorzugsweise die gleiche Vorgehensweise ergriffen. Dies ist jedoch nicht kritisch.

Vorzugsweise ist in mehreren der Verbindungsleitungen (insbesondere in allen Verbindungsleitungen) jeweils ein Schalter angeordnet und generiert die Steuerschaltung für die Schalter jeweils ein eigenes Zusatzsignal. In diesem Fall kann die Steuerschaltung entscheiden, welche der Schalter sie in den gesperrten Zustand überführt und welche der Schalter sie in den durchgeschalteten Zustand überführt. Es ist also ein dynamischer Betrieb möglich. Insbesondere kann die Steuerschaltung gezielt entscheiden, welche der Schaltelemente für den Laststrom verwendet werden sollen und welche nicht.

Beispielsweise ist es möglich, dass die Steuerschaltung (im Teillastbetrieb) die Schalter, die sie in den gesperrten Zustand überführt, zyklisch variiert. Dadurch wird eine thermische Belastung der Schaltelemente vergleichmäßigt. Alternativ ist es möglich, dass der Steuerschaltung ein jeweiliges Temperaturniveau des jeweiligen Schaltelements bekannt ist. In diesem Fall kann die Steuerschaltung (im Teillastbetrieb) diejenigen der Schalter in den gesperrten Zustand überführen, deren Schaltelemente das höchste Temperaturniveau aufweisen. In diesem Fall kann die Steuerschaltung gezielt die thermisch am höchsten belasteten Schaltelemente entlasten. Die anderen Schalter, also die nicht in den gesperrten Zustand überführten Schalter, befinden sich im durchgeschalteten Zustand.

Vorzugsweise sind zumindest bei denjenigen der Schaltelemente, bei denen in der jeweiligen Verbindungsleitung mit dem Ausgang der Treiberschaltung ein jeweiliger Schalter angeordnet ist, der jeweilige Steueranschluss und der jeweilige zweite Lastanschluss über eine jeweilige Schutzschaltung miteinander verbunden. Dadurch können die entsprechenden Steueranschlüsse vor unzulässigen Spannungen gegenüber den jeweiligen Lastanschlüssen geschützt werden.

Im einfachsten Fall ist die jeweilige Schutzschaltung eine ungesteuerte Schutzschaltung. In diesem Fall sind der jeweilige Steueranschluss und jeweilige zweite Lastanschluss über die jeweilige Schutzschaltung niederohmig miteinander verbunden, wenn ein Potenzial des jeweiligen Steueranschlusses ein Potenzial des jeweiligen zweiten Lastanschlusses um weniger als eine vorbestimmte Grenzspannung übersteigt oder unter dem Potenzial des jeweiligen zweiten Lastanschlusses liegt. Wenn hingegen das Potenzial des jeweiligen Steueranschlusses das Potenzial des jeweiligen zweiten Lastanschlusses zwar übersteigt, aber um weniger als die vorbestimmte Grenzspannung übersteigt, sind der jeweilige Steueranschluss und jeweilige zweite Lastanschluss über die jeweilige Schutzschaltung hochohmig miteinander verbunden. Dadurch wird der jeweilige Steueranschluss zuverlässig geschützt. Im einfachsten Fall kann die jeweilige Schutzschaltung als Zenerdiode ausgebildet sein.

Alternativ kann die jeweilige Schutzschaltung als gesteuerte Schutzschaltung ausgebildet sein. In diesem Fall ist die Schutzschaltung als jeweiliger weiterer Schalter ausgebildet, der von der Steuerschaltung angesteuert wird. Die Ansteuerung kann insbesondere invers zu dem in der jeweiligen Verbindungsleitung angeordneten jeweiligen Schalter angesteuert sein.

Die Schaltelemente können nach Bedarf ausgebildet sein. Vorzugsweise sind die Schaltelemente als spannungsgesteuerte Schaltelemente ausgebildet, insbesondere als IGBTs oder als FETs. Alternativ oder zusätzlich können die Schaltelemente als Niederspannungsschalter (geschaltete Spannung maximal 100 V, oftmals maximal 50 V, insbesondere 10 V bis 30 V) und/oder als GaN-Halbleiter ausgebildet sein. Andere Ausgestaltungen der Schaltelemente sind jedoch ebenfalls möglich.

Ebenso können auch die Schalter nach Bedarf ausgebildet sein. Vorzugsweise sind die Schalter als Niederspannungsschalter (Definition wie zuvor) mit integriertem Treiber und/oder als GaN-Halbleiter ausgebildet. Auch hier sind andere Ausgestaltungen der Schalter jedoch ebenfalls möglich.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: eine Stromstellerschaltung,
- FIG 2 bis 5: Zeitdiagramme,
- FIG 6 bis 8: Modifikationen der Stromstellerschaltung von FIG 1,
- FIG 9: ein Zeitdiagramm und
- FIG 10: ein Ablaufdiagramm.

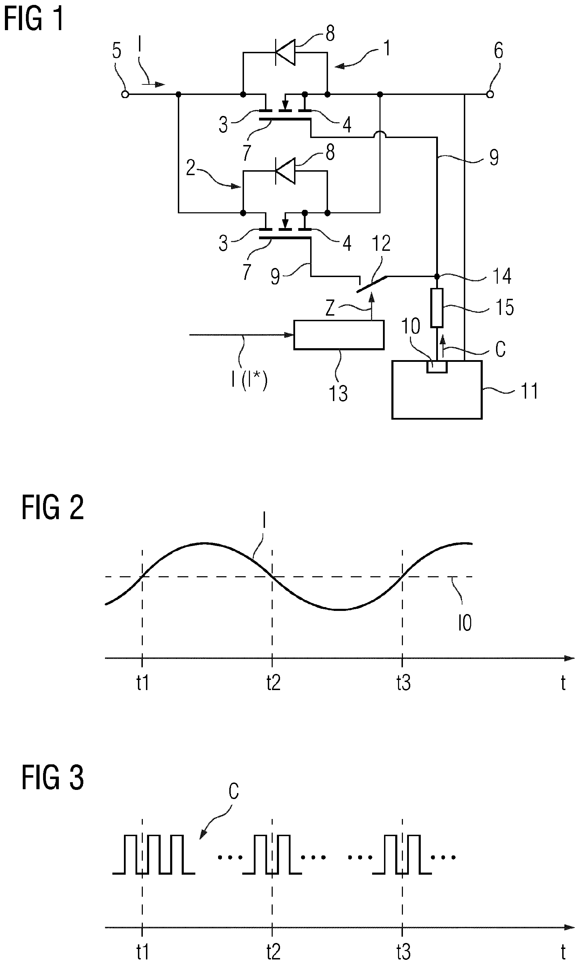

Gemäß FIG 1 weist eine Stromstellerschaltung eine Mehrzahl von Schaltelementen 1, 2 auf. Dargestellt ist in FIG 1 eine Minimalkonfiguration, bei der nur zwei Schaltelemente 1, 2 vorhanden sind. Diese Ausgestaltung ist für die weitaus meisten Anwendungsfälle völlig ausreichend. Es könnten aber auch mehr als zwei Schaltelemente 1, 2 vorhanden sein.

Nachfolgend wird der Aufbau des Schaltelements 1 näher erläutert. Gemäß FIG 1 weist das Schaltelement 1 einen ersten Lastanschluss 3 und einen zweiten Lastanschluss 4 auf. Der erste Lastanschluss 3 ist mit einem Lasteingang 5 der Stromstellerschaltung verbunden, der zweite Lastanschluss 4 mit einem Lastausgang 6 der Stromstellerschaltung. Weiterhin weist das Schaltelement 1 einen Steueranschluss 7 auf. Weiterhin ist üblicherweise dem Schaltelement 1 eine Diode 8 parallel geschaltet. Die Diode 8 kann eine intrinsische Diode des Schaltelements 1 sein. Alternativ kann es sich um ein eigenes Bauelement handeln. Das Schaltelement 1 kann entsprechend der Darstellung in FIG 1 als spannungsgesteuertes Schaltelement ausgebildet sein. Konkret ist das Schaltelement 1 in FIG 1 als FET ausgebildet. Es könnte aber ebenso auch anders ausgebildet sein, beispielsweise als IGBT.

Das Schaltelement 2 ist in aller Regel auf die gleiche Art und Weise wie das Schaltelement 1 aufgebaut. Für das Schaltelement 2 gelten daher analoge Ausführungen. Insbesondere sind auch die Lastanschlüsse 3, 4 des Schaltelements 2 mit dem Lasteingang 5 und dem Lastausgang 6 verbunden. Im Ergebnis sind somit die ersten Lastanschlüsse 3 der Schaltelemente 1, 2 miteinander verbunden und sind auch die zweiten Lastanschlüsse 4 der Schaltelemente 1, 2 miteinander verbunden.

In vielen Fällen wird mittels der Schaltelemente 1, 2 eine relativ hohe Spannung geschaltet, oftmals sogar eine Spannung oberhalb von 1 kV, im Extremfall bis 3 kV oder sogar 3,3 kV. Die Schaltelemente 1, 2 können aber auch als Niederspannungsschalter ausgebildet sein, die nur eine Spannung von 100 V oder weniger schalten. Bezüglich ihrer Technologie können die Schaltelemente 1, 2 auf prinzipiell beliebige Art und Weise ausgebildet sein. Besonders vorteilhaft ist jedoch, wenn die Schaltelemente 1, 2 als GaN-Halbleiter ausgebildet sind.

Die Steueranschlüsse 7 der Schaltelemente 1, 2 sind mittels einer jeweiligen Verbindungsleitung 9 mit einem Ausgang 10 einer Treiberschaltung 11 verbunden. Der Ausgang 10 ist ein für die Steueranschlüsse 7 gemeinsamer Ausgang. Ein Steuersignal C, das von der Treiberschaltung 11 über den Ausgang 10 ausgegeben wird, kann daher beiden Steueranschlüssen 7 zugeführt werden. In einer der Verbindungsleitungen 9, hier der Verbindungsleitungen 9 zum Steueranschluss 7 des Schaltelements 2, ist jedoch ein Schalter 12 angeordnet. Der Schalter 12 ist vorzugsweise als Niederspannungsschalter mit integriertem Treiber ausgebildet. Bezüglich seiner Technologie kann der Schalter 12 auf prinzipiell beliebige Art und Weise ausgebildet sein. Besonders vorteilhaft ist jedoch eine Ausbildung als GaN-Halbleiter.

Die Stromstellerschaltung weist weiterhin eine Steuerschaltung 13 auf. Von der Steuerschaltung 13 wird ein jeweiliges Zusatzsignal Z generiert. Das Zusatzsignal Z wird dem Schalter 12 zugeführt. Das Zusatzsignal Z ist binär. Je nach dem Wert des Zusatzsignals Z befindet sich der Schalter 12 entweder in einem durchgeschalteten oder in einem gesperrten Zustand. Wenn der Schalter 12 sich im durchgeschalteten Zustand befindet, wird das Steuersignal C den Steueranschlüssen 7 beider Schaltelemente 1, 2 zugeführt. Wenn der Schalter 12 sich hingegen im gesperrten Zustand befindet, wird das Steuersignal C nur dem Steueranschluss 7 des Schaltelements 1 zugeführt. Das Steuersignal C ist ebenfalls binär. Je nach dem Wert des Steuersignal C befinden sich die Schaltelemente 1, 2, denen das Steuersignal C zugeführt wird, entweder in einem durchgeschalteten oder in einem gesperrten Zustand.

Oftmals sind entsprechend der Darstellung in FIG 1 die Verbindungsleitungen 9 an einem Knotenpunkt 14 miteinander verbunden. In diesem Fall ist der Schalter 12 in der Verbindungsleitung 9 zwischen dem Knotenpunkt 14 und dem Steueranschluss 7 des Schaltelements 2 angeordnet. Weiterhin ist in der Regel zwischen dem Knotenpunkt 14 und dem Ausgang 10 der Treiberschaltung 11 ein Widerstand 15 angeordnet.

Nachstehend werden in Verbindung mit den FIG 2 bis 5 die Funktionsweise und der Betrieb der Stromstellerschaltung erläutert.

FIG 2 zeigt den von der Stromstellerschaltung geschalteten Strom I (Iststrom I) als Funktion der Zeit t. Da die geschaltete Spannung (nicht dargestellt) als im wesentlichen konstant angesehen werden kann, ist der Strom I charakteristisch für die über die Stromstellerschaltung geschaltete Leistung. Gemäß FIG 2 variiert der Strom I im Laufe der Zeit. Insbesondere übersteigt der Strom I zwischen Zeitpunkten t1 und t2 und ab einem Zeitpunkt t3 einen Schwellenwert 10, während er vor dem Zeitpunkt t1 und zwischen den Zeitpunkten t2 und t3 unterhalb des Schwellenwertes I0 liegt.

Zum Einstellen des Stromes I generiert die Treiberschaltung 11 das Steuersignal C, das seinen Signalpegel gemäß FIG 3 mit einer relativ hohen Frequenz ändert. Ein hoher Signalpegel korrespondiert mit einem Durchschalten der Schaltelemente 1, 2 bzw. mindestens eines der Schaltelemente 1, 2, so dass die entsprechenden Lastanschlüsse 3, 4 niederohmig miteinander verbunden sind. Ein Stromfluss ist daher möglich. Ein niedriger Signalpegel korrespondiert mit einem Sperren der Schaltelemente 1, 2, so dass die Lastanschlüsse 3, 4 der Schaltelemente 1, 2 hochohmig miteinander verbunden sind. Ein Stromfluss wird unterdrückt.

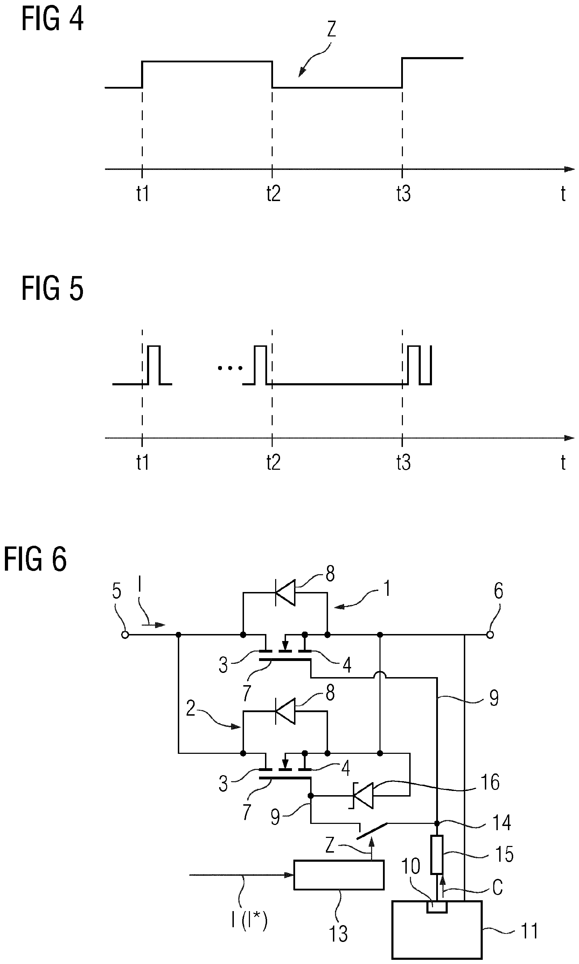

Liegt der (vorzeichenbehaftete) Iststrom I oberhalb des Schwellenwertes I0, so weist das Zusatzsignal Z gemäß FIG 4 einen hohen Signalpegel auf, anderenfalls einen niedrigen Signalpegel. Bei einem hohen Signalpegel ist der Schalter 12 durchgeschaltet, bei einem niedrigen Signalpegel gesperrt. Demzufolge wird das Steuersignal C (also das von der Treiberschaltung 11 über den Ausgang 10 abgegebene Signal) gemäß FIG 5 zwar zwischen Zeitpunkten t1 und t2 und ab dem Zeitpunkt t3 dem Steueranschluss 7 des Schaltelements 2 zugeführt, nicht aber vor dem Zeitpunkt t1 und zwischen den Zeitpunkten t2 und t3. Dem Steueranschluss 7 des Schaltelements 1 wird das Steuersignal C hingegen stets zugeführt.

Aus den FIG 4 und 5 ist insbesondere auch eine bevorzugte Ausgestaltung des Betriebs der Stromstellerschaltung ersichtlich. Insbesondere ist aus den FIG 4 und 5 ersichtlich, dass das Überführen des Schalters 12 vom durchgeschalteten in den gesperrten Zustand (und vorzugsweise auch vom gesperrten in den durchgeschalteten Zustand) nur dann erfolgt, wenn die Schaltelemente 1, 2 sich aufgrund des Steuersignals C in einem gesperrten Zustand befinden (Steuersignal C weist den niedrigen Pegel auf). Soweit erforderlich, wird mit das Umschalten des Zusatzsignals Z geringfügig verzögert, so dass die genannte Bedingung erfüllt ist.

Die vorstehenden Erläuterungen sind zwar prinzipiell korrekt, jedoch aus Gründen der besseren Erläuterung etwas vereinfacht.

Zum einen erfolgt das Umschalten oftmals mit einer gewissen Hysterese. Der Schwellenwert I0 ist also in einen oberen Schwellenwert und einen unteren Schwellenwert unterteilt. Das Zuschalten des Schaltelements 2 erfolgt erst, wenn der obere Schwellenwert überschritten wird. Ebenso erfolgt das Wegschalten des Schaltelements 2 erst, wenn der untere Schwellenwert unterschritten wird.

Zum anderen fließt innerhalb der in FIG 1 dargestellten Stromstellerschaltung bei gesperrten Schaltelementen 1, 2 natürlich kein Strom I. Im Sinne der Auswertung durch die Steuerschaltung 13 kann beispielsweise der beim unmittelbar vorhergehenden Durchschalten des Schaltelements 1 oder der Schaltelemente 1 und 2 fließende Strom I verwertet werden. Ebenso ist es möglich, dass der Stromstellerschaltung eine Induktivität vorgeordnet oder nachgeordnet ist und ein Stromfluss (kurzzeitig) auch bei gesperrten Schaltelementen 1, 2 aufrechterhalten bleibt. In diesem Fall kann dieser Wert des Stromes I verwendet werden.

Vorstehend wurde eine Vorgehensweise erläutert, bei welcher der Steuerschaltung 13 der mittels der Stromstellerschaltung geschaltete Iststrom I (bzw. ein entsprechender Messwert) zugeführt wird. In diesem Fall entscheidet die Steuerschaltung 13 anhand des Iststroms I, ob sie den Schalter 12 in den gesperrten Zustand überführt oder ob sie den Schalter 12 im durchgeschalteten Zustand hält. Alternativ ist es möglich, wie in FIG 1 in Klammern angedeutet, der Steuerschaltung 13 einen mittels der Stromstellerschaltung zu schaltenden Sollstrom I* zuzuführen (bzw. einen entsprechenden Sollwert). In diesem Fall kann die Steuerschaltung 13 die gleiche Entscheidung anhand des Sollstroms I* treffen.

In der vorstehend erläuterten Minimalkonfiguration ist nur ein einziger Schalter 12 vorhanden, der von der Steuerschaltung 13 in den gesperrten bzw. in den durchgeschalteten Zustand überführt werden kann. Es ist möglich, auch für das Schaltelement 1 einen entsprechenden Schalter vorzusehen. Auch wenn mehr als zwei Schaltelemente 1, 2 vorhanden sind, kann mehr als ein Schalter 12 vorhanden sein. In derartigen Fällen kann die Steuerschaltung 13 - gegebenenfalls auch mehrstufig - entscheiden, ob und gegebenenfalls welche der Schalter 12 sie in den gesperrten Zustand überführt.

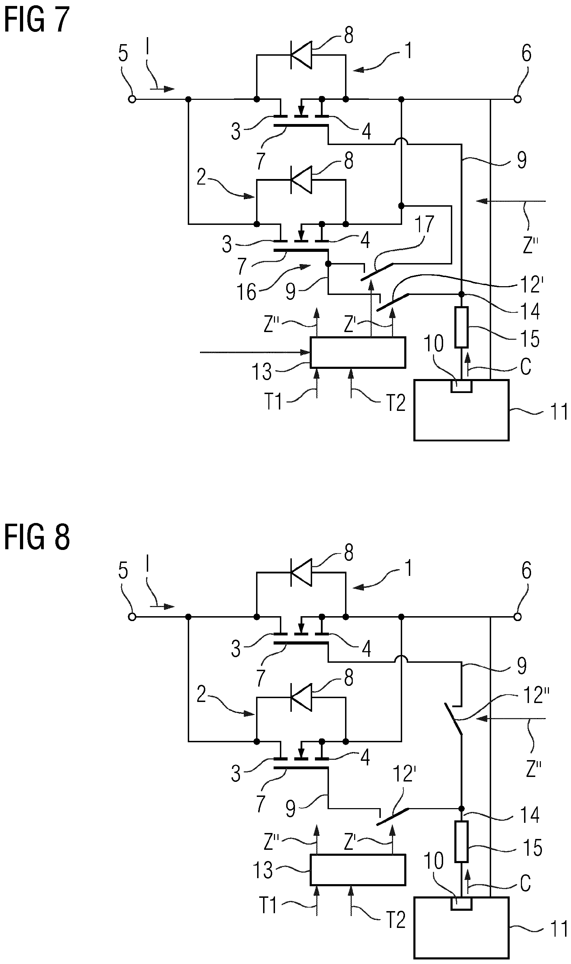

Die Stromstellerschaltungen der FIG 6 und 7 gehen aus von der Stromstellerschaltung von FIG 1. Nachstehend werden daher nur die Ergänzungen und Modifikationen erläutert.

Gemäß den FIG 6 und 7 ist eine Schutzschaltung 16 vorhanden. Über die Schutzschaltung 16 sind der Steueranschluss 7 und der zweite Lastanschluss 4 des Schaltelements 2 miteinander verbunden. Durch die Schutzschaltung 16 werden Überspannungen vermieden, welche das Schaltelement 2 schädigen könnten.

Bei der Ausgestaltung gemäß FIG 6 ist die Schutzschaltung 16 eine ungesteuerte Schutzschaltung. Sie wirkt wie folgt, wobei alle Aussagen auf das Schaltelement 2 bezogen sind:
- Wenn ein Potenzial des Steueranschlusses 7 unter einem Potenzial des zweiten Lastanschlusses 4 liegt, sind der Steueranschluss 7 und der zweite Lastanschluss 4 über die Schutzschaltung 16 niederohmig miteinander verbunden.
- Wenn das Potenzial des Steueranschlusses 7 über dem Potenzial des zweiten Lastanschlusses 4 liegt, sind der Steueranschluss 7 und der zweite Lastanschluss 4 über die Schutzschaltung 16 zunächst hochohmig miteinander verbunden.
- Wenn das Potenzial des Steueranschlusses 7 das Potenzial des zweiten Lastanschlusses 4 jedoch um mehr als eine vorbestimmte Grenzspannung übersteigt, sind der Steueranschluss 7 Schaltelements 2 und der zweite Lastanschluss 4 Schaltelements 2 über die Schutzschaltung 16 niederohmig miteinander verbunden.

Im einfachsten Fall ist die ungesteuerte Schutzschaltung entsprechend der Darstellung von FIG 6 als Zenerdiode ausgebildet, deren Zenerspannung die vorbestimmte Grenzspannung ist.

Bei der Ausgestaltung gemäß FIG 7 ist die Schutzschaltung 16 eine gesteuerte Schutzschaltung. In diesem Fall ist die Schutzschaltung 16 als weiterer Schalter 17 ausgebildet. Der weitere Schalter 17 wird von der Steuerschaltung 13 angesteuert. Die Ansteuerung kann insbesondere invers zu dem Schalter 12 erfolgen.

Wenn mehr als zwei Schalter 12 vorhanden sind, können die Ausgestaltungen der FIG 6 und 7 bei jedem Schaltelement 1, 2 realisiert werden, dessen Steueranschluss 7 über einen entsprechenden Schalter 12 von dem Ausgang 10 der Treiberschaltung 11 getrennt werden kann.

Nachfolgend wird in Verbindung mit FIG 8 eine weitere Modifikation der Stromstellerschaltung erläutert. Diese Modifikation wird ausgehend von der Stromstellerschaltung von FIG 1 erläutert. Sie kann aber nach Bedarf auch mit der Modifikation von FIG 6 oder der Modifikation von FIG 7 kombiniert werden.

Gemäß FIG 8 ist in mehreren der Verbindungsleitungen 9 jeweils ein Schalter 12', 12" angeordnet. Die Schalter 12', 12" weisen die gleiche Funktion wie der Schalter 12 von FIG 1 auf. Die Bezugszeichen 12 und 12' werden lediglich verwendet, um die beiden Schalter 12', 12" von FIG 8 einfacher voneinander unterscheiden zu können.

Gemäß FIG 8 generiert die Steuerschaltung 13 für die Schalter 12', 12" jeweils ein eigenes Zusatzsignal Z', Z". Auch die Zusatzsignale Z', Z" weisen die gleiche Funktion wie das Zusatzsignal Z von FIG 1 auf. Die Bezugszeichen Z' und Z" werden lediglich verwendet, um die beiden Zusatzsignale Z', Z" von FIG 8 einfacher voneinander unterscheiden zu können.

Im Falle der Ausgestaltung gemäß FIG 8 kann die Steuerschaltung 13 in dem Fall, dass sie überhaupt einen der Schalter 12', 12" in den gesperrten Zustand überführen will, entscheiden, welchen der Schalter 12', 12" sie in den gesperrten Zustand überführt und welchen sie in den durchgeschalteten Zustand überführt bzw. im durchgeschalteten Zustand hält. Hierfür gibt es verschiedene mögliche Vorgehensweisen.

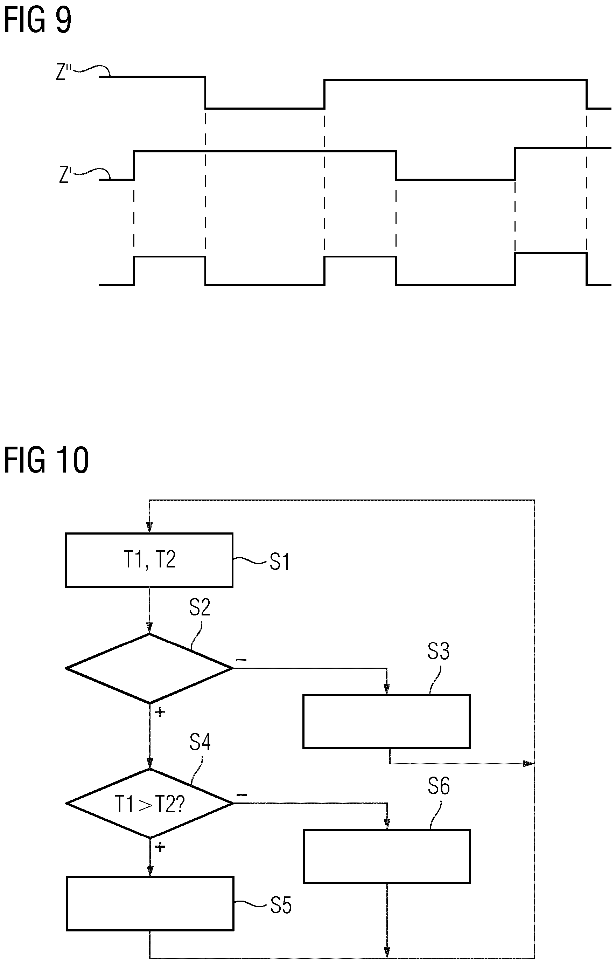

Im einfachsten Fall ist es entsprechend der Darstellung in FIG 9 möglich, dass die Steuerschaltung 13 die Schalter 12', 12", die sie in den gesperrten Zustand überführt, zyklisch variiert. Gemäß FIG 9 soll beispielsweise immer dann, wenn der Iststrom I (oder alternativ der Sollstrom I*) unter den Schwellenwert I0 sinkt (Teillastphasen), einer der Schalter 12', 12" gesperrt werden. Diese Phasen korrespondieren mit den Zeiträumen, in denen das unterste Signal von FIG 9, das nicht mit einem Bezugszeichen versehen ist, einen niedrigen Pegel aufweist. Wie aus FIG 9 erkennbar ist, weist während der ersten Teillastphase zunächst das Zusatzsignal Z' einen niedrigen Pegel auf, so dass der Schalter 12' gesperrt ist. Das Zusatzsignal Z" weist hingegen einen hohen Pegel auf, so dass der Schalter 12" durchgeschaltet ist. Während der zweiten Teillastphase ist es umgekehrt, so dass also der Schalter 12' durchgeschaltet ist, während der Schalter 12" gesperrt ist. Während der dritten Teillastphase ist wieder der Schalter 12' gesperrt, während der Schalter 12" durchgeschaltet ist. Während der vierten Teillastphase ist wieder der Schalter 12' durchgeschaltet, während der Schalter 12" gesperrt ist. Während der Volllastphasen hingegen, wenn also der Iststrom I (oder alternativ der Sollstrom I*) über dem Schwellenwert I0 liegt, sind beide Schalter 12', 12" durchgeschaltet.

Alternativ ist es (vergleiche wieder FIG 8) möglich, dass der Steuerschaltung 13 ein jeweiliges Temperaturniveau T1, T2 des jeweiligen Schaltelements 1, 2 bekannt ist. Es kann sich beispielsweise um eine Sperrschichttemperatur des jeweiligen Schaltelements 1, 2 oder um eine Temperatur eines Kühlkörpers (nicht dargestellt) handeln, der an das das jeweilige Schaltelement 1, 2 thermisch angekoppelt ist. Es kann sich alternativ um eine gemessene oder um eine modellgestützt ermittelte Temperatur handeln. In derartigen Fällen kann die Steuerschaltung 13 diejenigen der Schalter 12', 12" in den gesperrten Zustand überführen, deren Schaltelemente 1, 2 das höchste Temperaturniveau T1, T2 aufweisen. Eine mögliche Ausgestaltung dieser Vorgehensweise wird nachstehend in Verbindung mit FIG 10 erläutert.

Gemäß FIG 10 werden der Steuerschaltung 13 in einem Schritt S1 die Temperaturniveaus T1, T2 bekannt. In einem Schritt S2 prüft die Steuereinrichtung 13, ob eine Teillastphase vorliegt, also einer der Schalter 12', 12" gesperrt werden soll. Wenn dies nicht der Fall ist, schaltet die Steuereinrichtung 13 in einem Schritt S3 sowohl den Schalter 12' als auch den Schalter 12" durch. Das Steuersignal C wird daher beiden Schaltelementen 1, 2 zugeführt. Sodann geht die Steuereinrichtung 13 zum Schritt S1 zurück. Wenn hingegen eine Teillastphase vorliegt, geht die Steuereinrichtung 13 zu einem Schritt S4 über. Im Schritt S4 prüft die Steuereinrichtung 13, ob das Temperaturniveau T1 über dem Temperaturniveau T2 liegt. Wenn dies der Fall ist, sperrt die Steuereinrichtung 13 in einem Schritt S5 den Schalter 12'. Anderenfalls sperrt die Steuereinrichtung 13 in einem Schritt S6 den Schalter 12". Sowohl vom Schritt S5 als auch vom Schritt S6 aus geht die Steuereinrichtung wieder zum Schritt S1 zurück.

Zusammengefasst betrifft die vorliegende Erfindung somit folgenden Sachverhalt:
Eine Stromstellerschaltung weist eine Mehrzahl von Schaltelementen 1, 2 auf, die jeweils einen ersten und einen zweiten Lastanschluss 3, 4 und einen Steueranschluss 7 aufweisen. Die ersten Lastanschlüsse 3 sind miteinander verbunden. Auch die zweiten Lastanschlüsse 4 sind miteinander verbunden. Die Steueranschlüsse 7 sind mittels einer jeweiligen Verbindungsleitung 9 mit einem für die Steueranschlüsse 7 gemeinsamen Ausgang 10 einer Treiberschaltung 11 verbunden. In mindestens einer der Verbindungsleitungen 9 ist ein Schalter 12, 12', 12" angeordnet, so dass ein von der Treiberschaltung 11 über den Ausgang 10 ausgegebenes Steuersignal C je nachdem, ob der jeweilige Schalter 12, 12', 12" sich in einem durchgeschalteten oder in einem gesperrten Zustand befindet, dem entsprechenden Steueranschluss 7 zugeführt wird oder nicht. Die Stromstellerschaltung weist eine Steuerschaltung 13 auf, von der ein jeweiliges Zusatzsignal Z, Z', Z" generiert wird, das dem jeweiligen Schalter 12, 12', 12" zugeführt wird und aufgrund dessen der jeweilige Schalter 12, 12', 12" in den durchgeschalteten oder in den gesperrten Zustand überführt wird.

Die vorliegende Erfindung weist viele Vorteile auf. Insbesondere ist die Stromstellerschaltung einfach und robust und wird die Verlustleistung im Teillastbetrieb deutlich verringert.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Stromstellerschaltung,
- wobei die Stromstellerschaltung eine Mehrzahl von Schaltelementen (1, 2) aufweist, die jeweils einen ersten und einen zweiten Lastanschluss (3, 4) und einen Steueranschluss (7) aufweisen,
- wobei die ersten Lastanschlüsse (3) miteinander verbunden sind und die zweiten Lastanschlüsse (4) miteinander verbunden sind,
- wobei die Steueranschlüsse (7) mittels einer jeweiligen Verbindungsleitung (9) mit einem für die Steueranschlüsse (7) gemeinsamen Ausgang (10) einer Treiberschaltung (11) verbunden sind,
- wobei in mindestens einer der Verbindungsleitungen (9) ein Schalter (12, 12', 12") angeordnet ist, so dass ein von der Treiberschaltung (11) über den Ausgang (10) ausgegebenes Steuersignal (C) je nachdem, ob der jeweilige Schalter (12, 12', 12") sich in einem durchgeschalteten oder in einem gesperrten Zustand befindet, dem entsprechenden Steueranschluss (7) zugeführt wird oder nicht, und
- wobei die Stromstellerschaltung eine Steuerschaltung (13) aufweist, von der ein jeweiliges Zusatzsignal (Z, Z', Z") generiert wird, das dem jeweiligen Schalter (12, 12', 12") zugeführt wird und aufgrund dessen der jeweilige Schalter (12, 12', 12") in den durchgeschalteten oder in den gesperrten Zustand überführt wird.

2. Stromstellerschaltung nach Anspruch 1,
**dadurch gekennzeichnet,**
**dass** die Verbindungsleitungen (9) an einem Knotenpunkt (14) miteinander verbunden sind, dass die Schalter (12, 12', 12") in der jeweiligen Verbindungsleitung (9) zwischen dem Knotenpunkt (14) und dem jeweiligen Steueranschluss (7) angeordnet sind und dass zwischen dem Knotenpunkt (14) und dem Ausgang (10) der Treiberschaltung (11) ein Widerstand (15) angeordnet ist.

3. Stromstellerschaltung nach Anspruch 1 oder 2,
**dadurch gekennzeichnet,**
**dass** der Steuerschaltung (13) ein mittels der Stromstellerschaltung zu schaltender Sollstrom (I*) oder ein mittels der Stromstellerschaltung geschalteter Iststrom (I) zugeführt wird und dass die Steuerschaltung anhand des Sollstroms (I*) bzw. des Iststroms (I) entscheidet, ob sie mindestens einen der Schalter (12, 12', 12") in den gesperrten Zustand überführt oder ob sie alle Schalter (12, 12', 12") im durchgeschalteten Zustand hält.

4. Stromstellerschaltung nach Anspruch 1, 2 oder 3,
**dadurch gekennzeichnet,**
**dass** ein Überführen des jeweiligen Schalters (12, 12', 12") vom durchgeschalteten in den gesperrten Zustand nur dann erfolgt, wenn die Schaltelemente (1, 2) sich aufgrund des von der Treiberschaltung (11) ausgegebenen Steuersignals (C) in einem gesperrten Zustand befinden.

5. Stromstellerschaltung nach einem der obigen Ansprüche,
**dadurch gekennzeichnet,**
**dass** in mehreren der Verbindungsleitungen (9) jeweils ein Schalter (12', 12") angeordnet ist, dass die Steuerschaltung (13) für die Schalter (12', 12") jeweils ein eigenes Zusatzsignal (Z', Z") generiert und dass die Steuerschaltung (13) entscheidet, welche der Schalter (12', 12") sie in den gesperrten Zustand überführt und welche der Schalter (12', 12") sie in den durchgeschalteten Zustand überführt.

6. Stromstellerschaltung nach Anspruch 5,
**dadurch gekennzeichnet,**
**dass** die Steuerschaltung (13) die Schalter (12', 12"), die sie in den gesperrten Zustand überführt, zyklisch variiert.

7. Stromstellerschaltung nach Anspruch 5,
**dadurch gekennzeichnet,**
**dass** der Steuerschaltung (13) ein jeweiliges Temperaturniveau (T1, T2) des jeweiligen Schaltelements (1, 2) bekannt ist und dass die Steuerschaltung (13) diejenigen der Schalter (12', 12") in den gesperrten Zustand überführt, deren Schaltelemente (1, 2) das höchste Temperaturniveau (T1, T2) aufweisen.

8. Stromstellerschaltung nach einem der obigen Ansprüche,
**dadurch gekennzeichnet,**
**dass** zumindest bei denjenigen der Schaltelemente (1, 2), bei denen in der jeweiligen Verbindungsleitung (9) mit dem Ausgang (10) der Treiberschaltung (11) ein jeweiliger Schalter (12, 12', 12") angeordnet ist, der jeweilige Steueranschluss (7) und der jeweilige zweite Lastanschluss (4) über eine jeweilige Schutzschaltung (16) miteinander verbunden sind.

9. Stromstellerschaltung nach Anspruch 8,
**dadurch gekennzeichnet,**
**dass** die jeweilige Schutzschaltung (16) eine ungesteuerte Schutzschaltung ist, dass der jeweilige Steueranschluss (7) und jeweilige zweite Lastanschluss (4) über die jeweilige Schutzschaltung (16) niederohmig miteinander verbunden sind, wenn ein Potenzial des jeweiligen Steueranschlusses (7) ein Potenzial des jeweiligen zweiten Lastanschlusses (4) um weniger als eine vorbestimmte Grenzspannung übersteigt oder unter dem Potenzial des jeweiligen zweiten Lastanschlusses (4) liegt, und dass der jeweilige Steueranschluss (7) und jeweilige zweite Lastanschluss (4) über die jeweilige Schutzschaltung (16) hochohmig miteinander verbunden sind, wenn das Potenzial des jeweiligen Steueranschlusses (7) das Potenzial des jeweiligen zweiten Lastanschlusses (4) zwar übersteigt, aber um weniger als die vorbestimmte Grenzspannung übersteigt.

10. Stromstellerschaltung nach Anspruch 8,
**dadurch gekennzeichnet,**
**dass** die jeweilige Schutzschaltung (16) als jeweiliger weiterer Schalter (17) ausgebildet ist und dass der jeweilige weitere Schalter (17) von der Steuerschaltung (13) angesteuert wird, insbesondere invers zu dem in der jeweiligen Verbindungsleitung (9) angeordneten jeweiligen Schalter (12) angesteuert wird.

11. Stromstellerschaltung nach einem der obigen Ansprüche,
**dadurch gekennzeichnet,**
**dass** die Schaltelemente (1, 2) als spannungsgesteuerte Schaltelemente ausgebildet sind, insbesondere als IGBTs oder als FETs.

12. Stromstellerschaltung nach einem der obigen Ansprüche,
**dadurch gekennzeichnet,**
**dass** die Schaltelemente (1, 2) als Niederspannungsschalter und/oder als GaN-Halbleiter ausgebildet sind.

13. Stromstellerschaltung nach einem der obigen Ansprüche,
**dadurch gekennzeichnet,**
**dass** der jeweilige Schalter (12, 12', 12") als Niederspannungsschalter mit integriertem Treiber und/oder als GaN-Halbleiter ausgebildet ist.
